# EUROPÄISCHE PATENTSCHRIFT

(11) **EP 1 008 280 B1**
(45) Veröffentlichungstag und Bekanntmachung des Hinweises auf die Patenterteilung: **09.06.2004**
(21) Anmeldenummer: 99925031.9
(22) Anmeldetag: 25.05.1999
(51) Int. Cl.: H05K 7/12

(54) **KONTAKTIEREINHEIT FÜR EIN KARTENFÖRMIGES TRÄGERELEMENT ELEKTRONISCHER BAUGRUPPEN, INSBESONDERE NACH PCMCIA-NORM**
CONTACTING UNIT FOR A CARD-SHAPED CARRYING ELEMENT OF ELECTRONIC MODULES, ESPECIALLY ACCORDING TO PCMCIA STANDARDS
UNITE DE MISE EN CONTACT POUR UN ELEMENT DE SUPPORT EN FORME DE CARTE DE MODULES ELECTRONIQUES, EN PARTICULIER CORRESPONDANT A LA NORME PCMCIA

(30) Priorität: 29.06.1998 DE 29811425 U
(43) Veröffentlichungstag der Anmeldung: 14.06.2000
(73) Patentinhaber: Stocko Contact GmbH & Co. KG, 42327 Wuppertal (DE)
(72) Erfinder: KLATT, Dieter, D-42489 Wülfrath (DE)
(74) Vertreter: Stenger, Watzke & Ring Patentanwälte
(86) Internationale Anmeldenummer: PCT/EP1999/003560
(87) Internationale Veröffentlichungsnummer: WO 2000/001210

(56) Entgegenhaltungen:
- EP-A- 0 791 890
- WO-A-96/42063
- WO-A-97/10566
- DE-A- 4 432 028
- DE-U- 29 607 253
- DE-U- 29 621 835
- DE-U- 29 718 773
- FR-A- 2 753 597

## Beschreibung

Die Erfindung betrifft eine Kontaktiereinheit für ein kartenförmiges Trägerelement elektronischer Baugruppen, insbesondere nach PCMCIA-Norm, mit den Merkmalen des Oberbegriffs des Anspruchs 1. Eine derartige Kontaktiereinheit ist beispielsweise aus der WO 96142063 A bekannt.

Im Rahmen zunehmender Miniaturisierung im Bereich der Computertechnologie werden elektronische Bauteile im Hinblick auf Variabilität und Transportabilität immer öfter auf oder in kartenförmigen Trägerelementen angeordnet. Häufig anzutreffen sind Trägerelemente nach der PCMCIA-Norm, bei denen es sich um Karten handelt, die eine normgemäße matrixartige Verbindungsleiste aufweisen und je nach Verwendungszweck die unterschiedlichsten elektronischen Bauteile aufnehmen können. So finden derartige Karten beispielsweise als Speichererweiterungskarten, Laufwerkskarten, Modemkarten und dergleichen eine Anwendung. Der Anschluss an ein Datenverarbeitungssystem, wie beispielsweise ein Notebook, erfolgt über die Steckverbinderleiste, die mit einem PCMCIA-Steckplatz des Datenverarbeitungssystems eine mechanische und elektrische Kontaktierung bewirkt.

Weitverbreitet sind Chipkarten, die über eine IC-Schaltkreis verfügen und flächig angeordnete Kontaktfelder für die Kontaktierung mit beispielsweise entsprechend ausgebildeten Leseeinheiten aufweisen. Bekannte Anwendungsgebiete für Chipkarten sind derzeit Telefonkarten, Autorisierungskarten oder sogenannte Smart-Cards.

Im Stand der Technik sind Kontaktiereinheiten bekannt, die es ermöglichen, eine Chipkarte an einen nach PCMCIA-Standard genormten Anschluß eines Datenverarbeitungssystemes anzuschließen. Die Kombination einer PCMCIA-Karte und einer Chipkarten-Kontaktiereinheit, die in einen entsprechenden Modulaufnahmeschlitz eines Computer eingeschoben und gelesen werden kann, ist für verschiedenste Anwendungen anzutreffen, beispielsweise Electronic-Banking, Pay-TV, Sicherung einer Zugangsberechtigung zu Datennetzen und ähnliches. Nachteilig hierbei ist, daß die bekannten Chipkartenleser dieser Art sich eine über den Einschubbereich des Modulaufnahmeschlitzes des Computers hinaus erstreckende Gehäuseerweiterung in Form einer vergrößerten Einschubführung für die Chipkarte, die gleichzeitig eine Handhabungsleiste für den Benutzer darstellt, aufweisen. Hierdurch werden die Lesegeräte erheblich länger als die normierten PCMCIA-Karten und ragen in der Betriebsstellung mit dem Erweiterungsbereich aus dem Aufnahmeschlitz, beispielsweise eines Notebooks, hinaus, so daß die Gefahr besteht, daß in der mobilen Handhabung die Kontaktiereinheit im Schlitz verklemmt oder gar verbogen und beschädigt wird. Der Erweiterungsbereich wurde bislang für notwendig befunden, um eine sichere Führung der Chipkarte in den schlitzartigen Einschubkanal hinein und heraus ohne die Gefahr eines Verkantens zu gewährleisten, letztlich also um die Einführung, Arretierung und Entnahme einer Chipkarte zu gewährleisten.

Mit der ständig zunehmenden Hinwendung zu transportablen Computern, wie beispielsweise Laptops oder Notebooks, besteht technisch das Bedürfnis, daß ein in Betriebsbereitschaftsposition befindlicher Chipkartenleser vollständig in den Aufnahmeschlitz des Computers einschiebbar ist, ohne daß herausstehende Teile die Handhabung stören. Dies kommt beispielsweise dann zum Tragen, wenn mit einer einzuschiebenden Chipkarte die persönliche Autorisierung für den Computer vorzunehmen ist. Es sind zwar Kontaktiereinheiten bekannt, die keinen Erweiterungsbereich mehr aufweisen und demzufolge in der Länge der PCMCIA-Norm entsprechen, aber mit zumindest teilweise geschlossenen Seitenflächen versehen sind, um eine seitliche Führung der Chipkarte zu erreichen. Eine wesentliche Marktforderung ist allerdings, dass eine Kontaktiereinheit auch in der Breite exakt der PCMCIA-Norm entspricht, so dass selbst Wandstärken von 1/10 mm für die Seitenflächen eine nicht hinnehmbare Abweichung von der PCMCIA-Norm darstellen. Ein weiterer Nachteil sehr dünnwandiger Seitenflächen besteht darin, dass beim geringsten Verkanten der Chipkarte beim Einführen in die Kontaktiereinheit die Seitenflächen klingenartig die Chipkarte beschädigen können. Ein zusätzlicher Nachteil ergibt sich, wenn die dünnen Seitenflächen deformiert werden und dann ein Einführen der Chipkarte nicht mehr möglich ist.

Der Erfindung liegt die **Aufgabe** zugrunde, eine Kontaktiereinheit für ein kartenförmiges Trägerelement elektronischer Baugruppen dahingehend weiterzubilden, dass diese in einen PCMCIA-Schlitz eines Computers vollständig einschiebbar ist, ohne dass Teile herausragen, und zugleich eine sichere Einschubführung und hinreichende mechanische Stabilität bei einfacher Fertigung gewährleistet bleibt.

Diese Aufgabe ist bei einer Kontaktiereinheit mit den Merkmalen der eingangs genannten Art erfindungsgemäß **gelöst** durch die ergänzenden Merkmale gemäß dem kennzeichnenden Teil des Anspruchs 1.

Durch die erfindungsgemäßen Merkmale ist es möglich, eine Kontaktiereinheit bereitzustellen, deren Länge und Breite exakt der PCMCIA-Norm, beispielsweise Typ II, entspricht und die in vollem Umfang in PCMCIA-Schlitz eines Computers, beispielsweise Notebooks, einsetzbar ist, ohne dass Teile herausstehen. Durch die volle Versenkbarkeit lässt sich eine Beschädigungsgefahr, insbesondere beim Transport, ausschließen, wobei zusätzlich auch eine Schutzklappe vorgesehen sein kann, die den PCMCIA-Schlitz bei eingeschobener Kontaktiereinheit verschließt. In diesem Fall ist es freilich nicht möglich, eine Chipkarte in der Kontaktiereinheit zu lassen, da diese entsprechend der Länge des sich an den Einschubkanal anschließenden Bereiches im eingeschobenen Zustand aus der Kontaktiereinheit heraussteht.

In einer bevorzugten Ausführungsform der Erfindung stellt die Verbindung von Basisplatte und Abdeckplatte im sich in Einschubrichtung an den Einschubkanal anschließenden Bereich zugleich eine Schwenkachse dar, bezüglich der die Basisplatte und die Abdeckplatte in einem geringen Maße relativ zueinander derart verschwenkbar sind, daß die Höhe des Einschubkanals gegen die Wirkung einer Rückstellkraft veränderbar ist. Dies bietet den Vorteil, daß sich die Chipkarten beim Einschieben in den Einschubkanal klemmend halten läßt. Von besonderem Vorteil hierzu ist es, wenn sich die Höhe des Einschubkanals mit zunehmendem Abstand von der Verbindung bei entfernter Chipkarte verringert. Beim Einschieben der Chipkarte in den Einschubkanal wird dieser dann aufgeweitet und die Chipkarte aufgrund der damit einhergehenden elastischen Rückverformung sicher im Einschubkanal arretiert. Zugleich läßt sich auf diese Weise eine hohe Formstabilität der Kontaktiereinheit und eine Kompensation fertigungsbedingter Toleranzen erzielen.

Von besonderem Vorteil ist es ferner, die Leiterplatte an ihrem der Steckverbinderleiste gegenüberliegenden Ende mit einer die Leiterplatte im Gehäuse festlegenden Metalleiste zu verbinden, die federnd abstehende Lappen aufweist, welche an der metallenen Abdeckplatte elektrisch leitend anliegen. Die Metalleiste dient auf diese Weise einerseits zur niveaugleichen Halterung der Leiterplatte im Gehäuse und andererseits für einen Massenübergang zur Leiterplatte. Hinsichtlich letzterem ist es erforderlich, daß die Metalleiste mit Massekontaktflächen der Leiterplatte verbunden ist. Um eine einfache Montage zu erzielen, ist gemäß einem weiteren Merkmal der Erfindung die Metalleiste an einem mit der Abdeckplatte verbundenen, eine obere Einschubführung für die Chipkarte bildenden Kunststoffprofil angeordnet. Das Kunststoffprofil kann dabei auf seiner dem Einschubkanal zugewandten Seite mit Einfuhrschrägen für eine Chipkarte versehen und durch zum Beispiel Verklemmen, Verkleben oder Verrasten mit der Metalleiste verbunden sein.

Gemäß einer weiteren vorteilhaften Weiterbildung der Erfindung ist im Einschubkanal zumindest ein Federelement vorgesehen, dessen eines Ende fest mit der Abdeckplatte verbunden und dessen anderes, freies Ende lösbar an der Basisplatte festlegbar ist. Dem Federelement kommen dabei mehrere Aufgaben zu. Bei entfernter Chipkarte sichert das Federelement ein entgegen die Wirkung der Rückstellkraft gleichbleibende Höhe des Einschubkanals, so daß, sich die Chipkarte einfach einführen läßt. indem das freie Ende des Federelements lösbar an der Basisplatte festlegbar ist, wird zugleich der Einschubkanal vor einem Aufweiten nach Außen geschützt. Die Kontaktiereinheit erhält hierdurch eine zusätzliche Formstabilität. Durch das Einführen der Chipkarte wird das freie Ende gelöst und das Federelement im Einschubkanal in Richtung Abdeckplatte gebogen, so daß die Chipkarte aufgrund dieser Federwirkung mit einem die Kontaktsicherheit zusätzlich erhöhenden Druck beaufschlagt wird. Vorteilhafterweise ist das Federelement einstückig mit der Metalleiste gefertigt und erstreckt sich bei eingeschobener Chipkarte durch Aussparungen der Leiterplatte hindurch bis zur Abdeckplatte, so daß Chipkarte und metallene Abdeckplatte leitend miteinander verbunden werden, wodurch sich eine statische Aufladung der Chipkarte vermeiden läßt. Durch das Festlegen des freien Endes des Federelements an der Basisplatte läßt sich zudem eine Masseverbindung zwischen Abdeckplatte, Leiterplatte und Basisplatte bei entfernter Chipkarte erreichen. Die Metalleiste und das Federelement können durch Stanzen und Biegen als Bandware preisgünstig gefertigt und mittels Verstemmen, Kleben, Schweißen oder einer Ultraschallverschweißung in einem Arbeitsgang an der Abdeckplatte oder dem die obere Einschubführung bildenden Kunststoffprofil befestigt werden.

Um die Zug-Druck-Wirkung des Federelements zu erzielen, ist das Federelement zweckmäßigerweise annähernd S-förmig ausgebildet und an seinem freien Ende mit einem krallenförmigen Fortsatz versehen, der zum Festlegen des Federelements in ein korrespondierend ausgebildetes Rastelement eingreift. Von Vorteil hierzu ist es, gemäß einem weiteren Merkmal der Erfindung das Rastelement mit einer Hinterschneidung zu versehen, in welcher der krallenförmige Fortsatz des Federelements lösbar gehalten wird. In vorteilhafter Ausgestaltung der Erfindung wird weiterhin vorgeschlagen, daß das Rastelement in einer aus Kunststoff oder Metall bestehenden, mit der Basisplatte verbundenen Verstärkungsplatte ausgebildet ist. Während eine aus Kunststoff bestehende Verstärkungsplatte durch Spritzgießen mit der metallenen Basisplatte verbunden werden kann, läßt sich eine metallene Verstärkungsplatte mittels Schweißen oder Kleben an der Basisplatte befestigen. Vorteilhafterweise ist das Rastelement als separates Bauteil in die Verstärkungsplatte eingesetzt oder als Ausnehmung- in der zumindest einlagigen Verstärkungsplatte ausgebildet. Im letzten Fall kann die Hinterschneidung des Rastelements durch Stanzen oder Prägen einer einlagigen Verstärkungsplatte oder durch versetztes Anordnen zweier übereinanderliegenden, mit Öffnungen versehenen Verstärkungsplatten erzeugt werden. Ist das Rastelement hingegen als separates Bauteil ausgebildet, so ist es zweckmäßig, dieses vorgefertigt in eine Öffnung der Verstärkungsplatte einzulegen und zu verpressen.

Gemäß einem weiteren Merkmal der Erfindung ist die Basisplatte an ihrem der Steckverbinderleiste gegenüberliegenden Ende mit einem als eine untere Einschubführung dienenden Kunststoffprofil versehen, um ein einfaches Einführen einer Chipkarte sicherzustellen. Das Kunststoffprofil kann dabei analog zur oberen Einschubführung mit Einfuhrschrägen versehen sein.

In vorteilhafter Ausgestaltung der Erfindung wird ferner vorgeschlagen, daß die Basisplatte und die Abdeckplatte an der Steckverbinderleiste zu deren Erfassung jeweils mit randseitig angeordneten Kunststoffhaltern versehen sind, die durch eine Kunststoffverbindung, wie Kleben, Ultraschallschweißen oder Heißverpressen, fest miteinander verbindbar sind. Auf diese Weise läßt sich die feste Verbindung von Basisplatte und Abdeckplatte erzielen. Alternativ oder zusätzlich kann gemäß einem weiteren Merkmal der Erfindung die Basisplatte und die Abdeckplatte deckungsgleich und an seitlichen Schweißlaschen miteinander verschweißt sein. Von besonderem Vorteil hierzu ist es, wenn die Länge der festen Verbindung von Basisplatte und Abdeckplatte in etwa 30% der Gesamtlänge der Kontaktiereinheit beträgt, weil dann eine hohe Formstabilität der Kontaktiereinheit gegeben ist. Schließlich wird vorgeschlagen, daß ein Endschalter mit Anschlagwinkel zur Begrenzung der Einschubbewegung der Chipkarte vorgesehen ist. Je nach Anforderung kann die Einschubbewegung der Chipkarte auch durch die seitlichen Schweißlaschen oder die dann mit entsprechend ausgebildeten Anschlagsrundungen versehenen Kunststoffhaltern begrenzt werden.

Weitere Einzelheiten, Merkmale und Vorteile des Gegenstandes der Erfindung ergeben sich aus der nachfolgenden Beschreibung zweier Ausführungsbeispiele, die in den zugehörigen Zeichnungen dargestellt sind, und zwar zeigen im einzelnen:
- Fig. 1: eine perspektivische Darstellung einer Kontaktiereinheit bei nicht eingeschobener Chipkarte;
- Fig. 1a: eine perspektivische Ansicht der Kontaktiereinheit gemäß Fig. 1 bei eingeschobener Chipkarte;
- Fig. 2: die Einzelteile der Kontaktiereinheit gemäß Fig. 1 in Form aufgeklappt und auseinandergezogen dargestellter Gehäuseschalen sowie der inneren Bestückung in perspektivischer Ansicht;
- Fig. 3: die Einzelteile der Kontaktiereinheit gemäß Fig. 2 in einem Montage-Zwischenstadium;
- Fig. 3a: eine perspektivische Explosionsdarstellung der Befestigung einer Metalleiste an ein Kunststoffprofil;
- Fig. 3b: eine perspektivische Darstellung der Befestigung der Metalleiste gemäß Fig. 3a an eine Leiterplatte;.
- Fig. 4: eine schematische Seitenansicht der Kontaktiereinheit gemäß Fig. 1;
- Fig. 4a: eine schematische Seitenansicht der Kontaktiereinheit gemäß Fig. 1 a;
- Fig. 5: die Einzelteile einer alternativen Ausführungsform einer Kontaktiereinheit in Form aufgeklappt und auseinandergezogen dargestellter Gehäuseschalen sowie der inneren Bestückung in perspektivischer Ansicht;
- Fig. 6: die Einzelteile der Kontaktiervorrichtung gemäß Fig. 5 in einem Montage-Zwischenstadium;
- Fig. 7: eine schematische Seitenansicht der Kontaktiereinheit gemäß Fig. 5 bei nicht eingeschobener Chipkarte und
- Fig. 7a: eine schematische Seitenansicht gemäß Fig. 6 bei eingeschobener Chipkarte.

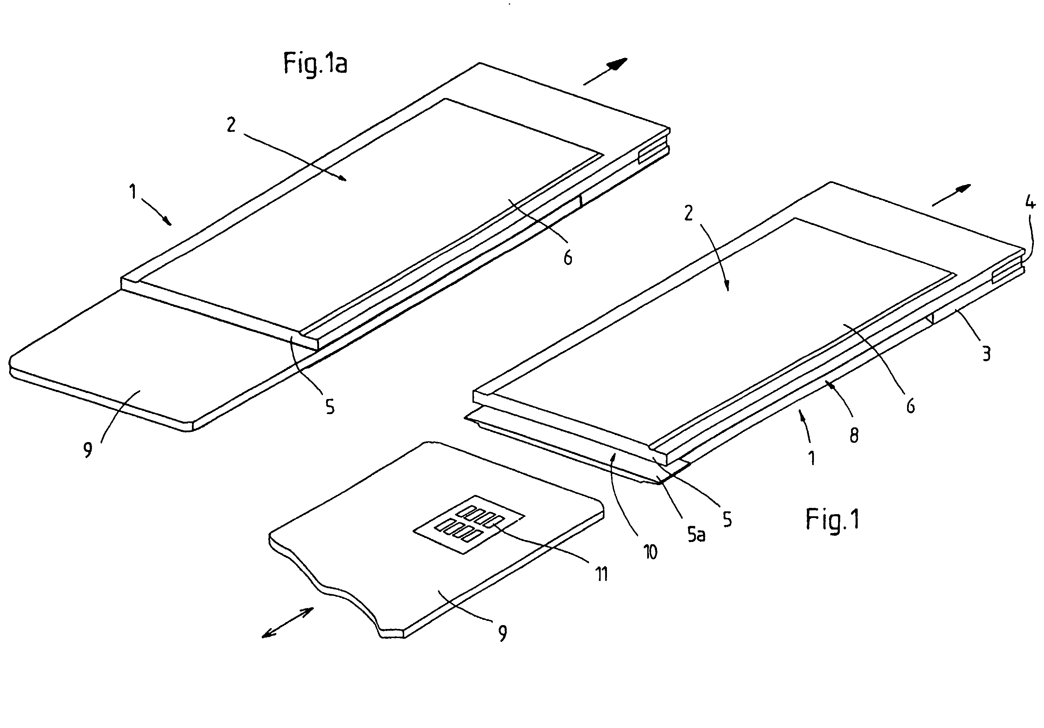

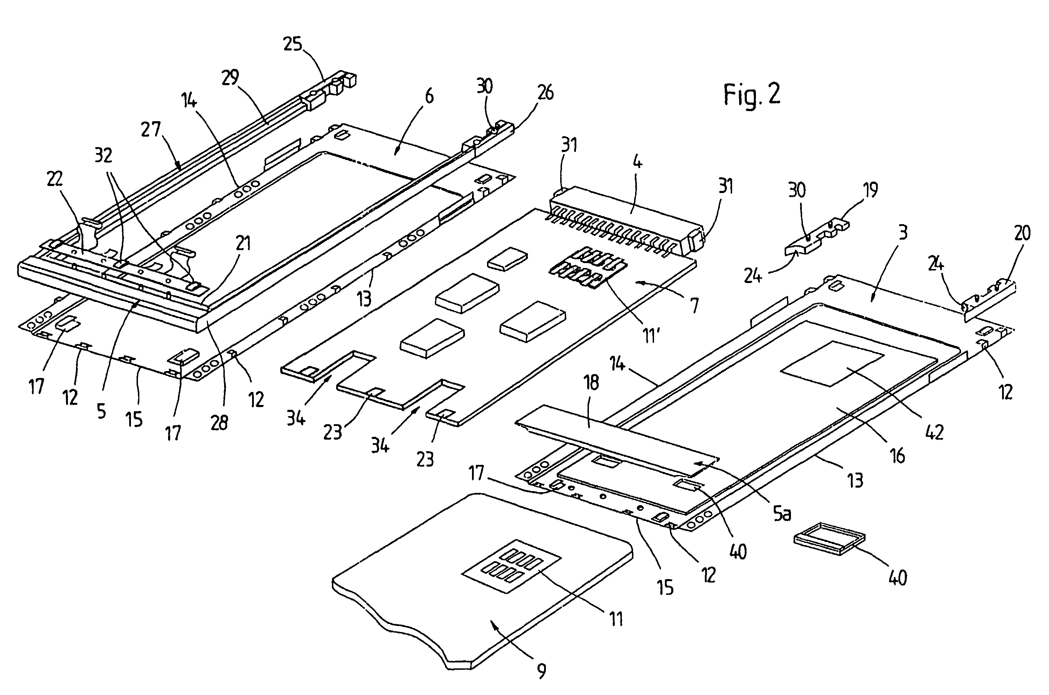

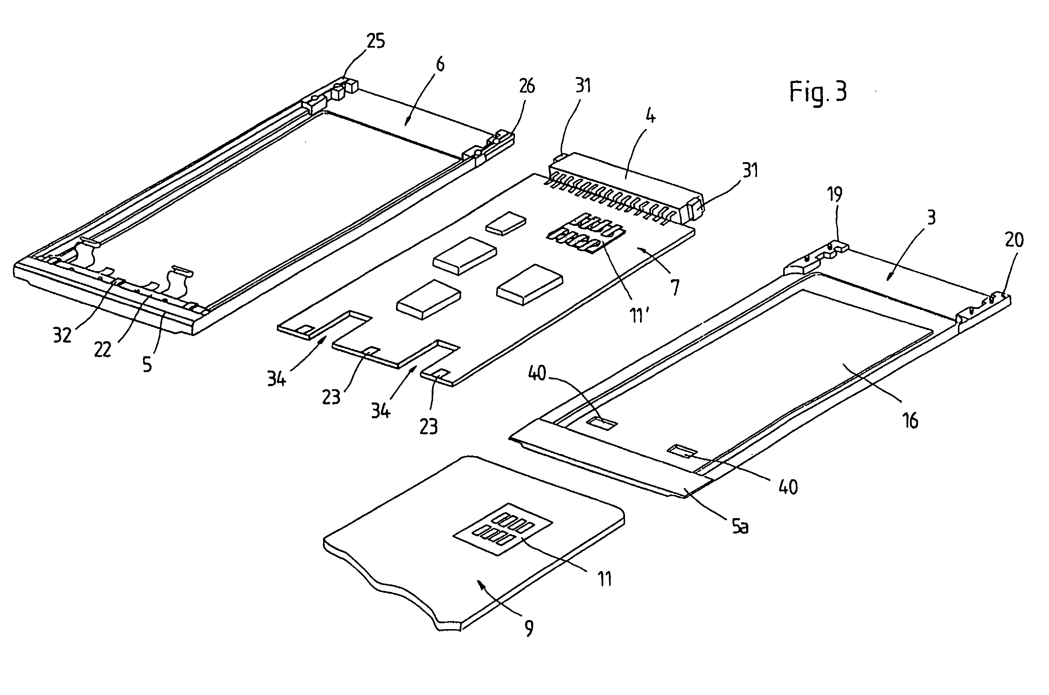

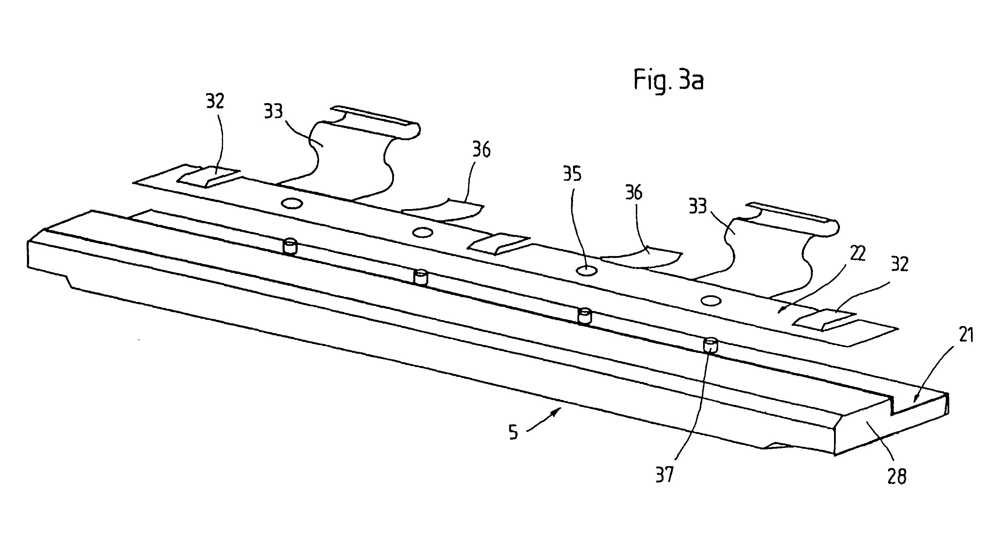

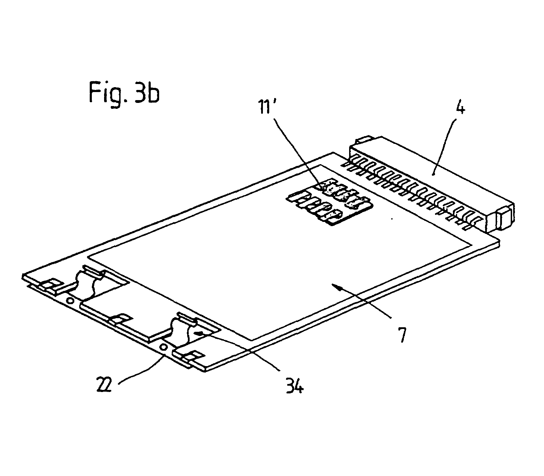

Das in Fig. 1 der Zeichnung dargestellte Ausführungsbeispiel der Erfindung zeigt eine als Chipkartenleser ausgebildete Kontaktiereinheit 1, die vorgesehen ist, über eine normgemäße PCMCIA-Schnittstelle mit einem Notebook kontaktiert zu werden. Die Kontaktiereinheit 1 besteht aus einem zweischaligen Außengehäuse 2 mit einer Basisplatte 3, einem PCMCIA-Anschlußfeld in Form einer Steckverbinderleiste 4 mit 68 Polen an dem in Einschubrichtung in das Notebook gemäß Pfeil vorderen Ende, eine obere und untere Einschubführung 5, 5a am gegenüberliegenden Ende für die Einführung einer Chipkarte 9 zum Beispiel nach ISO 78 16 und einer parallel mit Abstand zur Basisplatte 3 sich erstreckenden Abdeckplatte 6, welche mit der Basisplatte 3 im Bereich der Steckverbinderleiste 4 starr verbunden ist. Die genannten Teile der Kontaktiereinheit 1 werden von den in den Fig. 2 und 3 dargestellten innenliegenden Kunststoffprofilelementen aus PCB getragen, die darüber hinaus eine PCMCIA-Leiterplatte 7 mit Abstand parallel zur Basisplatte 3 derart halten, daß dazwischen ein Einschubkanal 8 für die ISO 78 16 Chipkarte 9 gebildet wird, die über einen Einschubschlitz 10 zwischen den Einschubführungen 5, 5a in die Kontaktiereinheit 1 einschiebbar ist. Die Chipkarte 9 läßt sich in Richtung des in Fig. 1 gezeigten Doppelpfeils in die Kontaktiereinheit 1 einschieben und aus dieser wieder herausziehen, wobei sich über das auf der Oberfläche angeordnete Chipfeld 11 der Chipkarte 9 und ein Kontaktfeld 11' auf der Unterseite der PCMCIA-Leiterplatte 7 eine Kontaktierung vornehmen läßt, die eine Verarbeitung der Chipkarte 9 über die PCMCIA-Karte ermöglicht, wenn die Kontaktiereinheit 1 in den Einschubschlitz des Notebooks eingesetzt und mit dessen PCMCIA-Schnittstelle über die Steckverbinderleiste 4 verbunden ist.

Fig. 2 zeigt die zwei einzelnen Schalen des Außengehäuses 1, nämlich die Basisplatte 3 in einer perspektivischen Ansicht auf die Innenseite und die Abdeckplatte 6, quasi um 180° aufgeklappt, ebenfalls in einer perspektivischen Ansicht auf die Innenseite. Basisplatte 3 und Abdeckplatte 6 sind separat handhabbare, nicht miteinander verbundene Blechteile mit nach innen gebogenen Krampen 12 an den Längsseiten 13, 14 und der in Einschubrichtung hinteren Stirnseite 15, während die in Einschubrichtung vordere Stirnseite frei bleibt, um dort später die Steckverbinderleiste 4 anordnen zu können. In dem in Fig. 2 dargestellten Ausführungsbeispiel ist die Basisplatte 3 mit einer eingeschweißten Verstärkungsplatte 16 versehen, die es ermöglicht, ein außerordentlich dünnes Gehäuseblech von etwa 2/10 mm Stärke zu verwenden. Es sei angemerkt, daß anstelle. einer Verstärkungsplatte 16 aus Metall auch eine solche aus Kunststoff Verwendung finden kann, die in einem einzigen Verfahrensschritt mit anderen, weiter unten beschriebenen Kunststoffteilen durch Spritzgießen hergestellt werden kann.

Die Krampen 12 weisen eine L-Form auf und es ist vorgesehen, diese aus dem Blech der Basisplatte 3 bzw. Abdeckplatte 6 freizustanzen, um 90° aus der Ebene nach innen hochzubiegen und sodann eine weitere Biegung um 90° nach innen vorzunehmen, so daß ein in den späteren Innenraum der Kontaktiereinheit 1 ragender freier Schenkel parallel zur Basisplatte 3 und Abdeckplatte 6 an den Krampen 12 vorhanden ist, der eine besonders günstige Halterung für eine weiter unten beschriebene Kunststoffumspritzung der Krampen 12 darstellt. Zahl und Anordnung der Krampen 12 an der Basis- und Abdeckplatte 3, 6 sind aufeinander in dem Sinne abgestimmt, ein möglichst torsionssteifes Gehäuse zu erzielen, wobei es sich als zweckmäßig erwiesen hat, an der Abdeckplatte 6 eine Vielzahl von Krampen 12 vorzusehen, während an der Basisplatte 3 das die untere Einschubführung 5a bildende Kunststoffprofilteil 18 mit Krampen 12 an der Stirnseite 15 und mit Haken 17 gehalten ist. Die Haken 17 sind ebenfalls aus dem Blechmaterial der Basisplatte 3 herausgestanzt und hochgebogen sowie L-förmig nach innen gebogen. Grundsätzlich ist es auch möglich, anstelle der aus dem Material der Basis- und Abdeckplatte herausgestanzten und gebogenen Krampen 12 und Haken 17 separate Halteelemente zu verwenden, die dann mit den Gehäuseschalen mechanisch verbunden werden müssen.

Fig. 2 zeigt weiterhin die für die innere Bestückung der Kontaktiereinheit 1 verwendeten Kunststoffprofile, die allerdings in der bevorzugten Ausführungsform nicht separat hergestellt und in das Gehäuse eingesetzt werden, sondern im Verbund mit den korrespondierenden Metallteilen des Gehäuses in einem einzigen Verfahrensschritt im Spritzgießverfahren hergestellt werden. Im in Einschubrichtung vorderen Bereich der Basisplatte 3 sind zur Halterung der Steckverbinderleiste 4 Kunststoffhatter 19, 20 vorgesehen, die gleichzeitig als Axialanschläge zur Begrenzung des Einschubs der Chipkarte 9 mit entsprechend gerundeten Anschlagflächen 24 ausgebildet sind.

Die Kunststoffhalter 19 korrespondieren mit entsprechend geformten Haltern 25, 26 an den freien Enden eines zur Abdeckplatte 6 gehörenden U-förmigen Kunststoffrahmens 27, der an seiner geschlossenen Seite eine als die obere Einschubführung 5 ausgebildete Leiste 28 aufweist, die mit einer plattformartigen Einsenkung 21 zur Befestigung einer Metalleiste 22 versehen ist. Die Längsschenkel des Kunststoffrahmens 27 weisen eine nach innen offene Führung in Form einer Abstufung 29 für die Erfassung und Halterung der Leiterplatte 7 auf, die durch den Kunststoffrahmen 27 in zusammengebautem Zustand fixiert wird, wobei die Halter 25, 26 gemeinsam mit den Kunststoffhaltern 19, 20 der Fixierung der mit der Leiterplatte 7 verbundenen Steckverbinderleiste 4 dienen. Die in den Fig. 2 und 3 dargestellten Kunststoffelemente sind ferner mit verschiedenen der Positionierung dienenden Positioniervorsprüngen und -ausnehmungen 30 versehen.

Die daneben gezeichnete Leiterplatte 7 wird derart auf der Abdeckplatte 6 um 180 geklappt angeordnet, daß frontseitig die an der Steckverbinderleiste 4 seitlich erkennbaren Nocken 31 in die entsprechenden Ausnehmungen der Kunststoffhalter 25, 26 eingreifen und gegenüberliegend Massekontaktflächen 23 der Leiterplatte 7 bündig unter Klemmkontakte 32 der Matelleiste 22 geschoben werden. Die Basisplatte 3 wird 180° geklappt der Abdeckplatte 6 zugeordnet. Hierdurch wird der Einschubkanal 8 zwischen der Basisplatte 3 und der Abdeckplatte 6 mit der Leiterplatte 7 gebildet, der zur Einführung der Chipkarte 9 frei bleibt und die Kontaktierung des Chipfeldes 11 über das Kontaktfeld 11' mit der PCMCIA-Karte ermöglicht.

Die Basisplatte 3 und die Leiterplatte 7 in den Fig. 2 und 3 sind nicht in der Montageposition dargestellt, sondern vielmehr um 180° aufgeklappt, um den Blick ins innere zu ermöglichen. Es ist erkennbar, daß der Abdeckplatte 6 der U-förmige Kunststoffrahmen 27 zugeordnet ist, der durch die entsprechenden Krampen 12 auf der Abdeckplatte 6 gehalten ist und auf den nach Montage mit der Leiterplatte 7 die in der beschriebenen Weise vorbereitete Basisplatte 3 aufgesetzt wird.

Darüber hinaus zeigt Fig. 3 im Unterschied zu Fig. 2 bereits die korrekte Anordnung der Kunststoffelemente auf der Basisplatte 3 bzw. Abdeckplatte 6, wobei erkennbar ist, daß die Krampen 12 nicht mehr zu sehen sind. Dies beruht auf dem bevorzugt bei der Herstellung der Kontaktiereinheit 1 benutzten Herstellungsverfahren, bei dem die äußeren Gehäuseschalen in Form der Basisplatte 3 und der Abdeckplatte 6 als separat handhabbare, nicht miteinander verbundene Blechteile gestanzt werden, wobei gleichzeitig die Krampen 12 und Haken 17 freigestanzt und einwärts gebogen werden; die Basisplatte 3 bzw. die Abdeckplatte 6 in einem zweiten Verfahrensschritt separat mit den Kunststoffhaltern 19, 20 und dem Kunststoffprofilteil 18 einerseits bzw. dem Kunststoffrahmen 27 andererseits durch einen Spritzgießvorgang in Form einer Verbundeinheit versehen werden; die Leiterplatte 7 mit ihrer Steckverbinderleiste 4 sodann von oben 180° geklappt auf die Abdeckplatte 6 aufgesetzt und an der Metalleiste 22 und den Kunststoffhaltern 25, 26 positioniert wird und in einem abschließenden Verfahrensschritt die derart vormontierten Gehäuseschalen mit innenliegenden Kunststoffelementen aufeinander angeordnet und durch eine Kunststoffverbindungstechnik, beispielsweise Kleben oder Ultraschallschweißen, miteinander verbunden werden.

Die Fig. 3a und 3b zeigen die Montage der Metalleiste 22 einerseits mit der oberen Einschubführung 5 und andererseits mit der Leiterplatte 7. Die klammerartigen Klemmkontakte 32 der Metalleiste 22 werden auf den Massekontaktflächen 23 der Leiterplatte 7 arretiert. Dadurch greifen einstückig an der Metalleiste 22 ausgebildete Federelemente 33 in Aussparungen 34 der Leiterplatte 7 ein, wie insbesondere Fig. 3b zu entnehmen ist. Die Metalleiste 22 ist zudem mit Bohrungen 35 und Massekontaktfedem 36 versehen. Die Bohrungen 35 wirken mit korrespondierend ausgebildeten Zapfen 37 auf der Einsenkung 21 der Leiste 28 zusammen, wodurch die Metalleiste 22 und damit die über die Klemmkontakte 32 mit der Metalleiste 22 verbundene Leiterplatte 7 auf der Abdeckplatte 6 zentriert wird. Durch anschließendes Ultraschallschweißen wird die Metalleiste 22 fixiert.

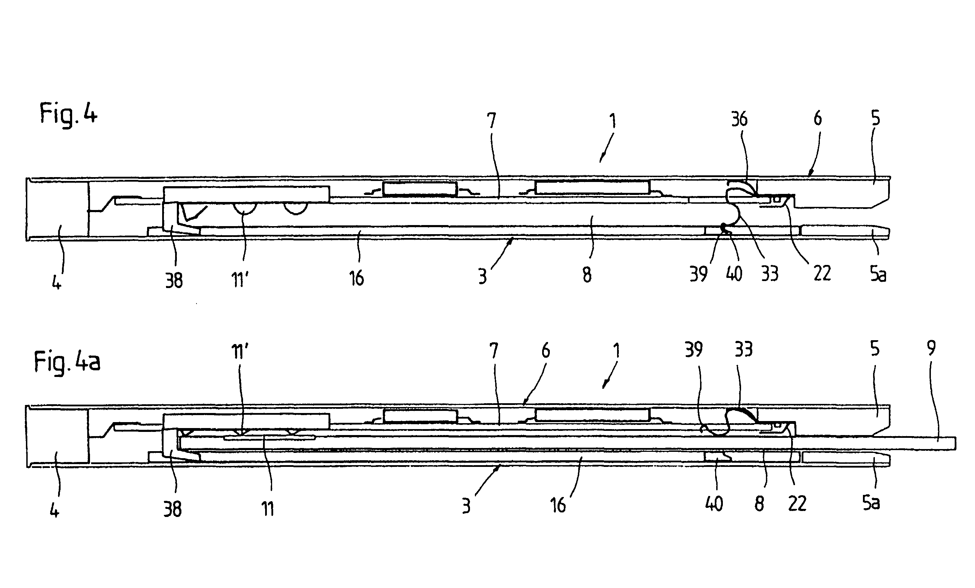

Den Fig. 4 und 4a ist die Funktionsweise der einstückig mit der Metalleiste 22 ausgebildeten Federelemente 33 zu entnehmen. Fig. 4 zeigt die Kontaktiereinheit 1 bei nicht eingeschobener Chipkarte 9, während in Fig. 4a zu erkennen ist, daß die Chipkarte 9 bis zu einem Endschalter mit Anschlagwinkel 38 in den Einschubkanal 8 eingeschoben ist, wobei das Chipfeld 11 der Chipkarte 9 an dem Kontaktfeld 11' der Leiterplatte 7 zu liegen kommt. Das Federelement 33 weist eine im wesentlichen S-förmige Gestalt auf und ist an seinem freien Ende mit einem krallenförmigen Fortsatz 39 versehen, der bei nicht eingeschobener Chipkarte 9 in ein als Ausnehmung in der Verstärkungsplatte 16 ausgebildetes Rastelement 40 unter Vorspannung eingreift. In Fig. 4a ist erkennbar, daß das Rastelement 40 eine Hinterschneidung aufweist, die sicherstellt, daß das Federelement 33 arretiert wird. Die Abdeckplatte 6 und die Basisplatte 3 sind durch die Kunststoffhalter 19, 20, 25, 26 derart miteinander verbunden, daß sie einer klammerartigen Kraft unterliegen. Durch das Federelement 33 wird sichergestellt, daß die Höhe des Einschubkanals 8 unverändert bleibt, wodurch sich ein einfaches Einführen der Chipkarte 9 erreichen läßt. Wird die Chipkarte 9 in den Einschubkanal 8 eingeführt, so drückt die in Einschubrichtung vordere Stirnseite der Chipkarte 9 das Federelement 33 in Richtung der Abdeckplatte, wobei das Federelement 33 durch die Aussparung 34 in der Leiterplatte 7 an die metallene Abdeckplatte 6 gedrückt wird. Dadurch läßt sich die Chipkarte 9 bis zum Endschalter 38 in den Einschubkanal 8 einführen und wird aufgrund der der Basisund Abdeckplatte 3, 6 immanenten Eigenspannung klemmend arretiert. Zusätzlich drückt das Federelement 33 auf die Chipkarte 9, so daß eine sichere Kontaktierung von Chipfeld 11 und Kontaktfeld 11' gewährleistet sind. Beim Herausziehen der Chipkarte 9 aus dem Einschubkanal 8 schwenkt das Federelement 33 wieder in das Rastelement 40, wodurch gleichzeitig auch eine Masseverbindung zwischen Metalleiste 22 respektive Abdeckplatte 6 und Basisplatte 3 hergestellt wird.

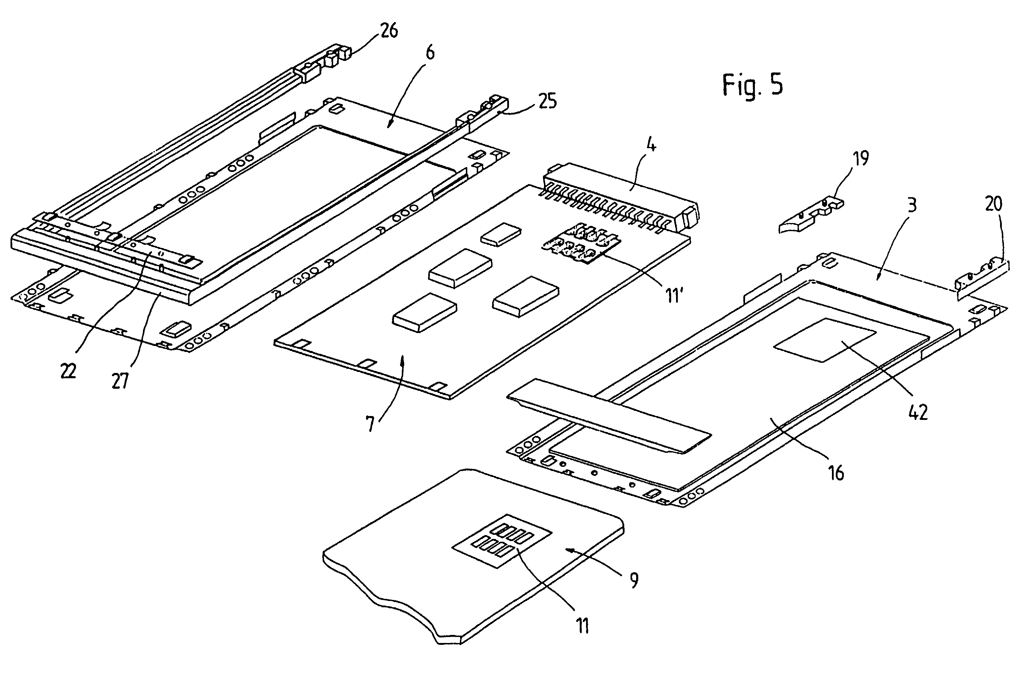

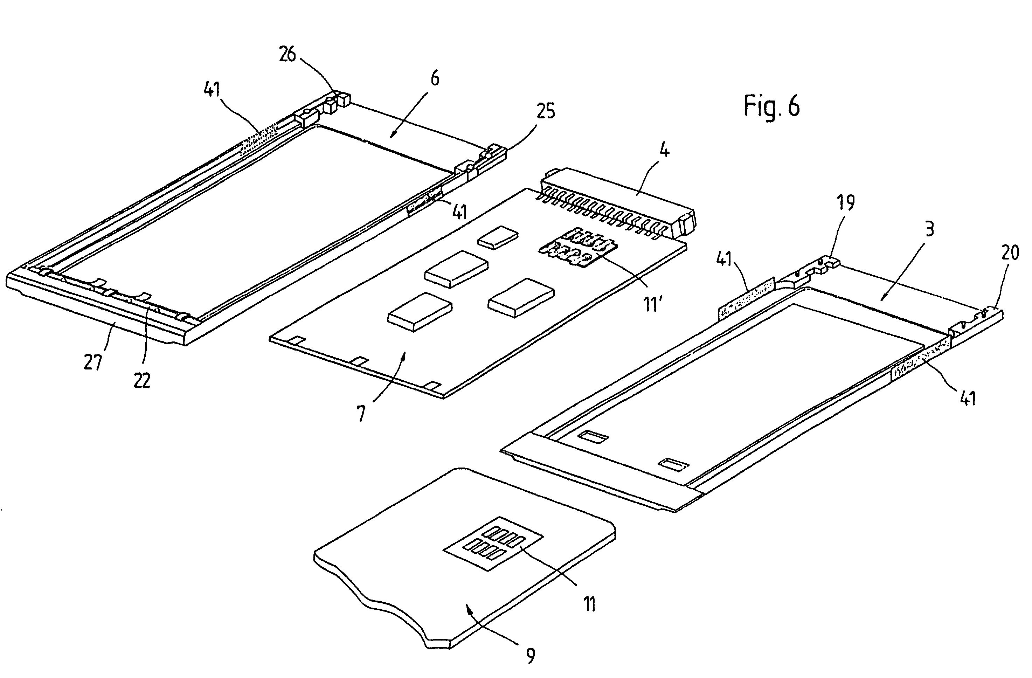

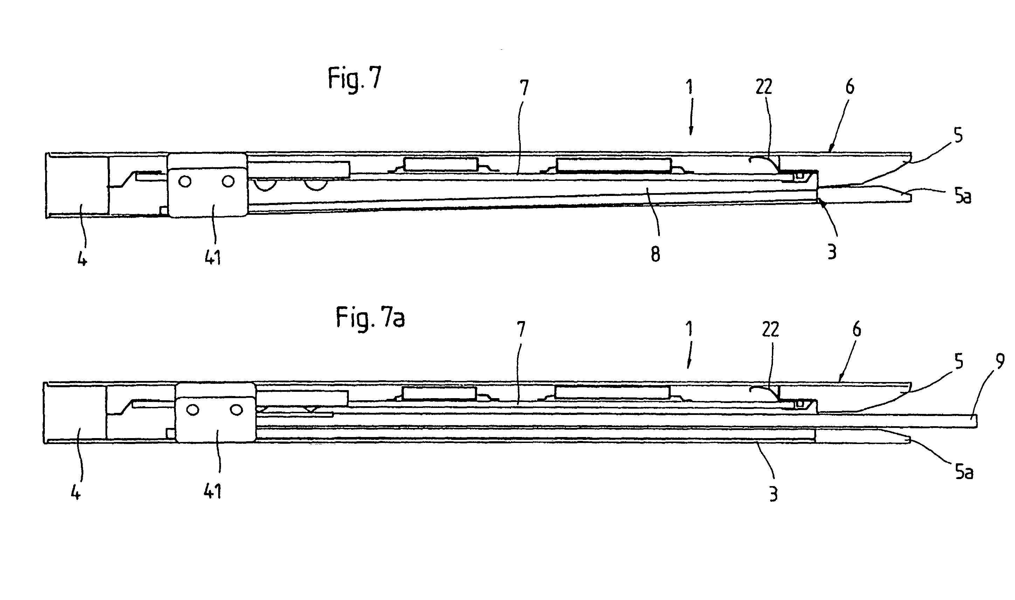

Die in den Fig. 5 bis 7a gezeigte alternative Ausführungsform der Kontaktiereinheit 1 weist im sich in Einschubrichtung an den Einschubkanal 8 anschließenden Bereich an Basisplatte 3 und Abdeckplatte 6 zusätzlich Schweißlaschen 41 auf, durch die Basisplatte 3 und Abdeckplatte 6 miteinander verbunden werden und die klammerartige Eigenspannung der Kontaktiereinheit 1 erzielt wird. Im Unterschied zur Ausführungsform gemäß den Fig. 2 bis 4a ist die Metalleiste 22 ohne das Federelement 33 ausgebildet, so daß bei entfernter Chipkarte 9 sich der Einschubkanal 8 der Kontaktiereinheit 1 von den gleichzeitig als Schwenkachse dienenden Schweißlaschen 41 aus in Richtung der oberen und unteren Einschubführung 5, 5a hin verjüngt. Bei Einschieben der Chipkarte 9 wird der Einschubkanal 8 unter Erzeugung einer Rückstellkraft aufgeweitet, wodurch die Chipkarte 9 klemmend im Einschubkanal 8 gehalten wird. Um ein Verschweißen der Schweißlaschen 41 zu ermöglichen, ohne die breiten Abmaße der PCMCIA-Norm zu verletzen, sind die Schweißlaschen 41 an der Abdeckplatte 6 gekröpft ausgebildet. Zusätzlich können in bekannter Weise die Kunststoffhalter 19, 20, 25 und 26 miteinander verschweißt sein.

Die Fig. 2 und 5 lassen erkennen, daß die Verstärkungsplatte 16 mit einer Isolierfolie oder -element 42 versehen sein kann, welches insbesondere zum Tragen kommt, wenn die Verstärkungsplatte 16 aus Metall gefertigt wird, so daß ein Kurzschluß zwischen dem gegenüberliegend angeordneten Kontaktfeld 11' der Leiterplatte 7 und der Verstärkungsplatte 16 ausgeschlossen werden kann. Darüber hinaus kann auf der Unterseite der Leiterplatte 7 eine verschleißfeste Isolierfolie aufgebracht sein, die Abrieb der Chipkarte 9 verhindert und gleichzeitig die Leiterbahnen und Durchkontaktierungen der Leiterplatte 7 auf der dem Einschubkanal 8 zugewandten Seite isoliert. In Fig. 2 ist außerdem zu erkennen, daß das Rastelement 40 auch als separates Bauteil ausgebildet sein kann, das in Ausnehmungen der Verstärkungsplatte 16 eingepreßt wird. Dies stellt eine besonders einfache und kostengünstige Fertigung dar. Um ein einfaches Einführen der Chipkarte 9 in den Einschubkanal 8 zu erzielen, kann zudem die untere Einschubführung 5a bezüglich der oberen Einschubführung 5 in Einschubrichtung der Chipkarte 9 voreilend in Form einer Unterlippe ausgebildet sein.

Mit der zuvor beschriebenen Kontaktiereinheit 1 ist ein Chipkartenleser geschaffen, der bei nicht eingesteckter Chipkarte exakt den PCMCIA-Abmaßen entspricht und der eine sichere Kontaktierung und hinreichende mechanische Stabilität aufweist. Die Sicherheit wird zudem dadurch erhöht, daß Abdeckplatte 6 und Basisplatte 3 deckungsgleich ausgebildet sind, so daß beim Einsetzen in den PCMCIA-Schlitz eines Computers Basisplatte 3 und Abdeckplatte 6 in den seitlichen Führungsnuten des PCMCIA-Schlitzes geführt werden. Dies verhindert, daß die Abdeckplatte 6 relativ zur Basisplatte 3 nach oben oder nach unten in einen angrenzenden PCMCIA-Schlitz des Computers gewaltsam gebogen werden kann. Durch die metallene Ausbildung von Basisplatte 3 und Abdeckplatte 6 ist darüber hinaus eine Abschirmung und eine hohe Funktions- und Formstabilität der Kontaktiereinheit 1 auch bei hohen Stau- und Umgebungstemperaturen oberhalb von 100°C gewährleistet. Nicht zuletzt zeichnet sich die Kontaktiereinheit 1 auch durch eine einfache und kostengünstige Herstellung aus.

### Bezugszeichenliste

- 1: Kontaktiereinheit
- 2: Außengehäuse
- 3: Basisplatte
- 4: Steckverbinderleiste
- 5: obere Einschubführung
- 5a: untere Einschubführung
- 6: Abdeckplatte
- 7: PCMCIA-Leiterplatte
- 8: Einschubkanal
- 9: Chipkarte
- 10: Einschubschlitz
- 11: Chipfeld
- 11': Kontaktfeld
- 12: Krampen
- 13: Längsseite
- 14: Längsseite
- 15: Stirnseite
- 16: Verstärkungsplatte
- 17: Haken
- 18: Kunststoffprofilteil
- 19: Kunststoffhalter
- 20: Kunststoffhalter
- 21: Einsenkung
- 22: Metalleiste
- 23: Massekontakt
- 24: Anschlagflächen
- 25: Kunststoffhalter
- 26: Kunststoffhalter
- 27: Kunststoffhalter
- 28: Leiste
- 29: Abstufung
- 30: Positioniervorsprung/-ausnehmung
- 31: Nocken
- 32: Klemmkontakt
- 33: Federelement
- 34: Aussparung
- 35: Bohrung
- 36: Massekontaktfeder
- 37: Zapfen
- 38: Endschalter
- 39: Fortsatz
- 40: Rastelement
- 41: Schweißlasche
- 42: Isolierelement

## Patentansprüche

1. Kontaktiereinheit für ein kartenförmiges Trägerelement elektronischer Baugruppen, insbesondere nach PCMCIA-Norm, mit einem steckkartenförmigen Gehäuse (2), das eine Basisplatte (3) und eine zumindest in Querrichtung deckungsgleiche Abdeckplatte (6) aufweist, zwischen denen ein an einer Stirnseite des Gehäuses (2) mündender, schlitzartiger Einschubkanal (8) für die Aufnahme einer Chipkarte (9) ausgebildet ist, und das an der dieser gegenüberliegenden Stirnseite mit einer Steckverbinderleiste (4) versehen ist, und mit einer parallel zum Einschubkanal (8) im Gehäuse (2) angeordneten Leiterplatte (7), die elektrisch mit der Steckverbinderleiste (4) verbunden und an ihrer Oberfläche mit einem Kontaktfeld (11') für die Kontaktierung der Chipkarte (9) versehen ist, wobei der Einschubkanal (8) über seine gesamte Länge in Einschubrichtung der Chipkarte (9) beidseitig durchgehend offen ist, und dass die Basisplatte (3) und die Abdeckplatte (6) ausschließlich im sich in Einschubrichtung an den Einschubkanal (8) anschließenden Bereich fest miteinander verbunden sind,
**dadurch gekennzeichnet,**
**dass** die Verbindung von Basisplatte (3) und Abdeckplatte (6) im sich in Einschubrichtung an den Einschubkanal (8) anschließenden Bereich zugleich eine Schwenkachse darstellt, bezüglich der die Basisplatte (3) und die Abdeckplatte (6) in einem geringen Maße relativ zueinander derart verschwenkbar sind, dass die Höhe des Einschubkanals (8) gegen die Wirkung einer Rückstellkraft veränderbar ist.

2. Kontaktiereinheit nach Anspruch 1, **dadurch gekennzeichnet, dass** sich die Höhe des Einschubkanals (8) mit zunehmendem Abstand von der Verbindung bei entfernter Chipkarte (9) verringert.

3. Kontaktiereinheit nach Anspruch 1 oder Anspruch 2, **dadurch gekennzeichnet, dass** die Leiterplatte (7) an ihrem der Steckverbinderleiste (4) gegenüberliegenden Ende mit einer die Leiterplatte (7) im Gehäuse (2) festlegenden Metallleiste (22) verbunden ist, die federnd abstehende Lappen (36) aufweist, welche an der metallenen Abdeckplatte (6) elektrisch leitend anliegen.

4. Kontaktiereinheit nach Anspruch 3, **dadurch gekennzeichnet, dass** die Metallleiste (22) an einem mit der Abdeckplatte (6) verbundenen, eine obere Einschubführung (5) für die Chipkarte (9) bildenden Kunststoffprofil (18) angeordnet ist.

5. Kontaktiereinheit nach einem der Ansprüche 1 bis 4, **dadurch gekennzeichnet, dass** im Einschubkanal (8) zumindest ein Federelement (33) vorgesehen ist, dessen eines Ende fest mit der Abdeckplatte (6) verbunden und dessen anderes, freies Ende lösbar an der Basisplatte (3) festlegbar ist.

6. Kontaktiereinheit nach Anspruch 5, **dadurch gekennzeichnet, dass** das Federelement (33) einstückig mit der Metallleiste (22) gefertigt ist und sich bei eingeschobener Chipkarte (9) durch Aussparungen (34) der Leiterplatte (7) hindurch bis zur Abdeckplatte (6) erstreckt.

7. Kontaktiereinheit nach Anspruch 5 oder 6, **dadurch gekennzeichnet, dass** das Federelement (33) annähernd S-förmig ausgebildet und an seinem freien Ende mit einem krallenförmigen Fortsatz (39) versehen ist, der zum Festlegen des Federelements (33) in ein korrespondierend ausgebildetes Rastelement (40) eingreift.

8. Kontaktiereinheit nach Anspruch 7, **dadurch gekennzeichnet, dass** das Rastelement (40) mit einer Hinterschneidung versehen ist.

9. Kontaktiereinheit nach Anspruch 7 oder 8, **dadurch gekennzeichnet, dass** das Rastelement (40) in einer aus Kunststoff oder Metall bestehenden, mit der Basisplatte (3) verbundenen Verstärkungsplatte (16) ausgebildet ist.

10. Kontaktiereinheit nach Anspruch 9, **dadurch gekennzeichnet, dass** das Rastelement (40) als separates Bauteil in die Verstärkungsplatte (16) eingesetzt oder als Ausnehmung in der zumindest einlagigen Verstärkungsplatte (16) ausgebildet ist.

11. Kontaktiereinheit nach einem. der Ansprüche 1 bis 10, **dadurch gekennzeichnet, dass** die Basisplatte (3) an ihrem der Steckverbinderleiste (4) gegenüberliegenden Ende mit einem als eine untere Einschubführung (5a) dienenden Kunststoffprofil (18) versehen ist.

12. Kontaktiereinheit nach einem der Ansprüche 1 bis 11, **dadurch gekennzeichnet, dass** die Basisplatte (3) und die Abdeckplatte (6) an der Steckverbinderleiste (4) zu deren Erfassung jeweils mit randseitig angeordneten Kunststoffhaltem (19, 20, 25, 26) versehen sind, die durch eine Kunststoffverbindung wie Kleben, Ultraschallschweißen oder Heißverpressen, fest miteinander verbindbar sind.

13. Kontaktiereinheit nach einem, der Ansprüche 1 bis 12, **dadurch gekennzeichnet, dass** die Basisplatte (3) und die Abdeckplatte (6) deckungsgleich und an seitlichen Schweißlaschen (41) miteinander verschweißt sind.

14. Kontaktiereinheit nach einem der Ansprüche 1 bis 13, **dadurch gekennzeichnet, dass** ein Endschalter (38) mit Anschlagwinkel zur Begrenzung der Einschubbewegung der Chipkarte (9) vorgesehen ist.

## Claims

1. Contact unit for a carrier element in card form of electronic components, in particular to PCMCIA standard, with a housing (2) in the shape of a slot-in card which has a base plate (3) and a cover plate (6) which is congruent at least in the transverse direction, between which there is formed a slot-like insertion channel (8) which opens on one end face of the housing (2) for receiving a chip card (9), and which is provided with a connector strip (4) on the end face lying opposite the said open end face, and with a printed circuit board (7) which is disposed in the housing (2) parallel to the insertion channel (8), is electrically connected to the connector strip (4) and is provided on its surface with a contact field (11') for contacting the chip card (9), wherein the insertion channel (8) is continuously open on both sides over it entire length in the direction of insertion of the chip card (9), and that the base plate (3) and the cover plate (6) securely connected to one another exclusively in the region adjoining the insertion channel (8) in the direction of insertion, **characterised in that** the connection of the base plate (3) and the cover plate (6) in the region adjoining the insertion channel (8) in the direction of insertion simultaneously constitutes a swivel axis in relation to which the base plate (3) and the cover plate (6) can swivel relative to one another in such a way that the height of the insertion channel (8) is variable against the effect of a restoring force.

2. Contact unit as claimed in Claim 1, **characterised in that** the height of the insertion channel (8) decreases as the distance from the connection increases when the chip card (9) is not inserted.

3. Contact unit as claimed in Claim 1 or Claim 2, **characterised in that** the printed circuit board (7) is provided on its end lying opposite the connector strip (4) with a metal strip (22) which fixes the printed circuit board (7) in the housing (2) and has resiliently projecting tabs (36) which rest in an electrically conductive manner on the metal cover plate (6).

4. Contact unit as claimed in Claim 3, **characterised in that** the metal strip (22) is disposed on plastic profile (18) which is connected to the cover plate (6) and forms an upper insertion guide (5) for the chip card (9).

5. Contact unit as claimed in one of Claims 1 to 4, **characterised in that** at least one spring element (33) is provided in the insertion channel (8), wherein one end of the spring element is securely connected to the cover plate (6) and the other, free end thereof can be releasably fixed on the base plate (3).

6. Contact unit as claimed in Claim 5, **characterised in that** the spring element (33) is produced integrally with the metal strip (22) and extends through cut-outs (34) in the printed circuit board (7) as far as the cover plate (6) when a chip card (9) is inserted.

7. Contact unit as claimed in Claim 5 or 6, **characterised in that** the spring element (33) is approximately S-shaped and is provided at its free end with a claw-shaped extension (39) which engages in a correspondingly constructed latching element (40) for fixing the spring element (33).

8. Contact unit as claimed in Claim 7, **characterised in that** the latching element (40) is provided with an undercut.

9. Contact unit as claimed in Claim 7 or 8, **characterised in that** the latching element (40) is constructed in a reinforcing plate (16) which is made from plastic or metal and is connected to the base plate (3).

10. Contact unit as claimed in Claim 9, **characterised in that** the latching element (40) is inserted as a separate component into the reinforcing plate (16) or is constructed as a recess in the reinforcing plate (16) which comprises at least one layer.

11. Contact unit as claimed in one of Claims 1 to 10, **characterised in that** the base plate (3) is provided on its end lying opposite the connector strip (4) with a plastic profile (18) which serves as a lower insertion guide (5a).

12. Contact unit as claimed in one of Claims 1 to 11, **characterised in that** the base plate (3) and the cover plate (6) are each provided on the connector strip with plastic holders (19, 20, 25, 26) disposed at the edges for gripping the connector strip, wherein the said plastic holders can be securely connected to one another by a plastic joining technique such as adhesion, ultrasound welding or hot-pressing.

13. Contact unit as claimed in one of Claims 1 to 12, **characterised in that** the base plate (3) and the cover plate (6) are congruent and are welded to one another at lateral weld brackets (41).

14. Contact unit as claimed in one of Claims 1 to 13, **characterised in that** an end stop (38) with a stop angle is provided for limiting the insertion movement of the chip card (9).

## Revendications

1. Unité de mise en contact destinée à un élément en forme de carte porteur d'ensembles électroniques, répondant notamment à la norme PCMCIA, avec un boîtier (2) en forme de carte enfichable qui, d'une part, comporte une plaque de base (3) et un panneau de recouvrement (6) coïncidant au moins dans le sens de la largeur et entre lesquels un canal d'insertion (8) en forme de fente débouchant sur une face frontale du boîtier (2) est réalisé pour recevoir une carte à puce (9), et qui, d'autre part, est muni d'une barrette de connexion multibroche (4) sur l'autre face frontale opposée à la première, et avec une plaquette à circuits imprimés (7) disposée dans le boîtier (2) parallèlement au canal d'insertion (8), laquelle est reliée électriquement à la barrette de connexion multibroche (4) et est munie à sa surface d'un banc de contacts (11') servant à la mise en contact de la carte à puce (9), le canal d'insertion (8) étant continûment ouvert des deux côtés sur toute sa longueur, dans la direction d'insertion de la carte à puce (9), et la plaque de base (3) et le panneau de recouvrement (6) étant solidement reliés ensemble exclusivement dans la zone se raccordant au canal d'insertion (8) dans la direction d'insertion,
**caractérisée en ce que**
la liaison de la plaque de base (3) et du panneau de recouvrement (6) située dans la zone se raccordant au canal d'insertion (8) dans la direction d'insertion constitue en même temps un axe de pivotement par rapport auquel la plaque de base (3) et le panneau de recouvrement (6) peuvent, dans une faible mesure, pivoter l'un par rapport à l'autre de telle sorte que la hauteur du canal d'insertion (8) soit modifiable à l'encontre de l'effet d'une force de rappel.

2. Unité de mise en contact selon la revendication 1, **caractérisée en ce que**, après retrait de la carte à puce (9), la hauteur du canal d'insertion (8) diminue au fur et à mesure que l'on s'éloigne de la liaison.

3. Unité de mise en contact selon la revendication 1 ou la revendication 2, **caractérisée en ce que**, à son extrémité opposée à la barrette de connexion multibroche (4), la plaquette à circuits imprimés (7) est reliée à une baguette métallique (22) qui immobilise la plaquette à circuits imprimés (7) dans le boîtier (2) et qui comporte des pattes (36) faisant saillie de manière élastique, lesquelles s'appliquent de manière électriquement conductrice contre le panneau de recouvrement (6) en métal.

4. Unité de mise en contact selon la revendication 3, **caractérisée en ce que** la baguette métallique (22) est disposée sur un profilé (18) en matière synthétique relié au panneau de recouvrement (6) et formant un guide d'insertion supérieur (5) pour la carte à puce (9).

5. Unité de mise en contact selon l'une des revendications 1 à 4, **caractérisée en ce qu'**il est prévu, dans le canal d'insertion (8), au moins un élément élastique (33) dont la première extrémité est solidement reliée au panneau de recouvrement (6) et dont l'autre extrémité, libre, peut être fixée de manière amovible à la plaque de base (3).

6. Unité de mise en contact selon la revendication 5, **caractérisée en ce que** l'élément élastique (33) est fabriqué d'une seule pièce avec la baguette métallique (22) et s'étend, après introduction de la carte à puce (9), jusqu'au panneau de recouvrement (6) à travers des encoches (34) ménagées dans la plaquette à circuits imprimés (7).

7. Unité de mise en contact selon la revendication 5 ou 6, **caractérisée en ce que** l'élément élastique (33) est réalisé approximativement en forme de S et est muni à son extrémité libre d'un prolongement en forme de griffe (39) qui, pour immobiliser l'élément élastique (33), rentre dans un élément d'encliquetage (40) conformé de manière correspondante.

8. Unité de mise en contact selon la revendication 7, **caractérisée en ce que** l'élément d'encliquetage (40) est muni d'une contre-dépouille.

9. Unité de mise en contact selon la revendication 7 ou 8, **caractérisée en ce que** l'élément d'encliquetage (40) est réalisé dans une plaque de renforcement (16) qui est faite de matière synthétique ou de métal et qui est reliée à la plaque de base (3).

10. Unité de mise en contact selon la revendication 9, **caractérisée en ce que** l'élément d'encliquetage (40) est inséré dans la plaque de renforcement (16) en tant que pièce séparée ou est réalisé sous forme d'évidement dans la plaque de renforcement (16) au moins monocouche.

11. Unité de mise en contact selon l'une des revendications 1 à 10, **caractérisée en ce que** la plaque de base (3) est munie, à son extrémité opposée à la barrette de connexion multibroche (4), d'un profilé en matière synthétique (18) servant de guide d'insertion inférieur (5a).

12. Unité de mise en contact selon l'une des revendications 1 à 11, **caractérisée en ce que** la plaque de base (3) et le panneau de recouvrement (6) sont chaque fois munis, au niveau de la barrette de connexion multibroche (4), pour saisir cette dernière, de supports en matière synthétique (19, 20, 25, 26) disposés sur les côtés, lesquels peuvent être reliés solidement ensemble en réalisant une liaison de matière synthétique telle qu'un collage, un soudage par ultrasons ou une compression à chaud.

13. Unité de mise en contact selon l'une des revendications 1 à 12, **caractérisée en ce que** la plaque de base (3) et le panneau de recouvrement (6) sont soudés ensemble de manière coïncidente et au moyen de languettes de soudure latérales (41).

14. Unité de mise en contact selon l'une des revendications 1 à 13, **caractérisée en ce qu'**un commutateur de fin de course (38) avec équerre de butée est prévu pour limiter le déplacement d'insertion de la carte à puce (9).
